# EUROPEAN PATENT APPLICATION

(11) **EP 4 665 130 A1**
(43) Date of publication of application: **17.12.2025**
(21) Application number: 23921189.9
(22) Date of filing: 10.02.2023
(51) Int. Cl.: H10N 60/12

(54) **QUANTUM COMPUTATION SYSTEM AND QUANTUM DEVICE MANUFACTURING METHOD**

(71) Applicant: FUJITSU LIMITED, Kawasaki-shi, Kanagawa 211-8588 (JP)
(72) Inventor: SAIDA, Daisuke, Kawasaki-shi, Kanagawa 211-8588 (JP)
(74) Representative: Hoffmann Eitle
(86) International application number: PCT/JP2023/004561
(87) International publication number: WO 2024/166360

(57) **Abstract**

A quantum computation system (1) has a quantum device (21), and a control device (10) that controls the quantum device. The quantum device has a first qubit (100), a second qubit (200), a flux qubit (300) for coupling that can couple with the first qubit and the second qubit, and a first magnetic flux application unit (340) that applies a magnetic flux to the flux qubit for coupling. The control device causes the first magnetic flux application unit to apply a first magnetic flux, which is provided with a first time modulation, during a first time period, and apply a second magnetic flux, which is provided with a second time modulation differing from the first time modulation, during a second time period differing from the first time period. This quantum computation system can be used, for example, in quantum computing.

## Description

### TECHNICAL FIELD

The present disclosure relates to quantum computation systems and quantum device control methods.

### BACKGROUND ART

In the related art, there is a proposed quantum computation system capable of coupling two flux qubits using flux qubits.

### PRIOR ART DOCUMENTS

### PATENT DOCUMENTS

Patent Document 1: International Publication Pamphlet No. WO 2008/029815
Patent Document 2: Japanese National Publication of International Patent Application No. 2019-508876
Patent Document 3: Japanese National Publication of International Patent Application No. 2022-525910

### DISCLOSURE OF THE INVENTION

### PROBLEM TO BE SOLVED BY THE INVENTION

In the quantum computation system of the related art, the coupling between the qubits cannot be cut, and an interaction may occur due to unnecessary coupling.

An object of the present disclosure is to provide a quantum computation system and a quantum device control method that can turn off a coupling of two qubits.

### MEANS OF SOLVING THE PROBLEM

According to an embodiment of the present disclosure, a quantum computation system includes a quantum device, and a control device configured to control the quantum device, wherein the quantum device includes a first qubit, a second qubit, a coupling flux qubit coupleable to the first qubit and the second qubit, and a first magnetic flux application unit configured to apply a magnetic flux to the coupling flux qubit, and wherein the control device causes the first magnetic flux application unit to apply a first magnetic flux having a first time modulation during a first time period, and apply a second magnetic flux having a second time modulation different from the first time modulation during a second time period different from the first time period.

### EFFECTS OF THE INVENTION

According to the present disclosure, the coupling of two qubits can be turned off.

### BRIEF DESCRIPTION OF THE DRAWINGS

[FIG. 1] FIG. 1 is a block diagram illustrating a quantum computation system according to a first embodiment.
[FIG. 2] FIG. 2 is a circuit diagram illustrating a quantum device according to the first embodiment.
[FIG. 3] FIG. 3 is a timing chart illustrating a temporal variation of a magnetic flux applied to a SQUID during a first time period.
[FIG. 4] FIG. 4 is a timing chart illustrating the temporal variation of the magnetic flux applied to the SQUID during a second time period.
[FIG. 5] FIG. 5 is a diagram (part 1) illustrating an energy state of a flux qubit.
[FIG. 6] FIG. 6 is a diagram (part 2) illustrating the energy state of the flux qubit.
[FIG. 7] FIG. 7 is a diagram (part 1) illustrating a result of a first simulation.
[FIG. 8] FIG. 8 is a diagram (part 2) illustrating the result of the first simulation.
[FIG. 9] FIG. 9 is a timing chart (part 1) illustrating the temporal variation of the magnetic flux applied to the SQUID during the second time period in a second simulation.
[FIG. 10] FIG. 10 is a timing chart (part 2) illustrating the temporal variation of the magnetic flux applied to the SQUID during the second time period in the second simulation.
[FIG. 11] FIG. 11 is a timing chart (part 3) illustrating the temporal variation of the magnetic flux applied to the SQUID during the second time period in the second simulation.
[FIG. 12] FIG. 12 is a timing chart (part 4) illustrating the temporal variation of the magnetic flux applied to the SQUID during the second time period in the second simulation.
[FIG. 13] FIG. 13 is a diagram (part 1) illustrating a result of the second simulation.
[FIG. 14] FIG. 14 is a diagram (part 2) illustrating the result of the second simulation.
[FIG. 15] FIG. 15 is a diagram (part 1) illustrating a result of a third simulation.
[FIG. 16] FIG. 16 is a diagram (part 2) illustrating the result of the third simulation.
[FIG. 17] FIG. 17 is a block diagram illustrating the quantum computation system according to a second embodiment.
[FIG. 18] FIG. 18 is a circuit diagram illustrating the quantum device according to the second embodiment.
[FIG. 19] FIG. 19 is a timing chart illustrating temporal variations of a current generated by a current source and the magnetic flux applied to the SQUID during the first time period.
[FIG. 20] FIG. 20 is a timing chart illustrating the temporal variations of the current generated by the current source and the magnetic flux applied to the SQUID during the second time period.
[FIG. 21] FIG. 21 is a diagram illustrating a relationship between a magnetic flux of a coupling flux qubit and an internal current of a charge qubit to be coupled to the coupling flux qubit.
[FIG. 22] FIG. 22 is a plan view illustrating a first example of a configuration of the quantum device according to the second embodiment.
[FIG. 23] FIG. 23 is a cross sectional view illustrating the first example of the configuration of the quantum device according to the second embodiment.
[FIG. 24] FIG. 24 is a cross sectional view illustrating a portion of a qubit substrate according to the second embodiment.
[FIG. 25] FIG. 25 is a cross sectional view illustrating a portion of another qubit substrate according to the second embodiment.
[FIG. 26] FIG. 26 is a plan view illustrating a second example of the configuration of the quantum device according to the second embodiment.
[FIG. 27] FIG. 27 is a cross sectional view illustrating a second example of the configuration of the quantum device according to the second embodiment.
[FIG. 28] FIG. 28 is a plan view illustrating a third example of the configuration of the quantum device according to the second embodiment.

### MODE OF CARRYING OUT THE INVENTION

Hereinafter, embodiments of the present disclosure will be described in detail with reference to the accompanying drawings. In the specification and the drawings, constituent elements having substantially the same functional configuration are designated by the same reference numerals, and a redundant description thereof may be omitted.

### (First Embodiment)

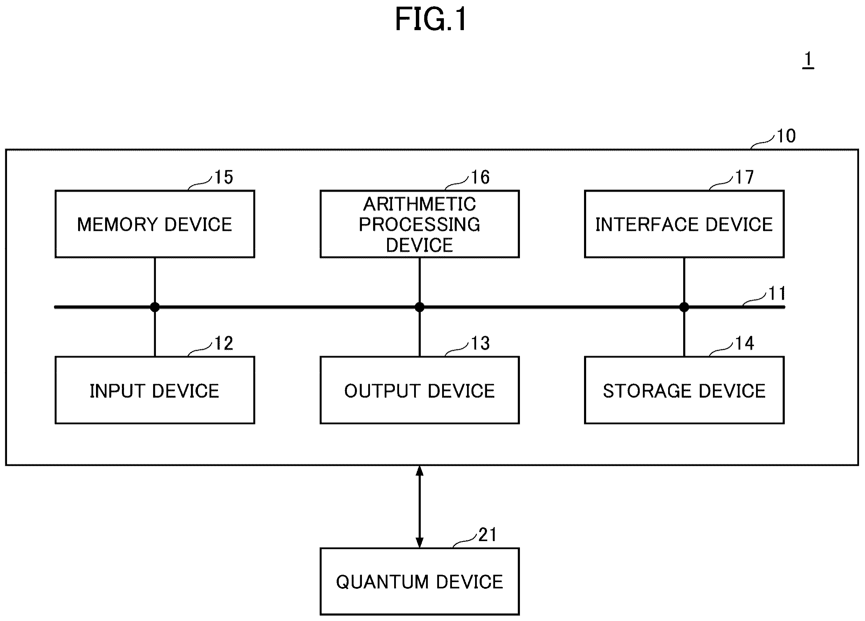

First, a first embodiment will be described. The first embodiment relates to a quantum computation system. FIG. 1 is a block diagram illustrating the quantum computation system according to a first embodiment.

A quantum computation system 1 according to the first embodiment includes a control device 10, and a quantum device 21. The control device 10 controls the quantum device 21.

The control device 10 is a computer, and includes a bus 11, an input device 12, an output device 13, a storage device 14, a memory device 15, an arithmetic processing device 16, and an interface device 17. The input device 12, the output device 13, the storage device 14, the memory device 15, the arithmetic processing device 16, and the interface device 17 are connected to a bus 11. The input device 12, the output device 13, the storage device 14, the memory device 15, the arithmetic processing device 16, and the interface device 17 are connected to one another via the bus 11.

The input device 12 is a device for inputting various kinds of information, and is implemented by a keyboard, a pointing device, or the like, for example. The output device 13 is a device for outputting various kinds of information, and is implemented by a display or the like, for example. The interface device 17 includes a LAN card or the like, and is used for making a connection to a network.

The storage device 14 stores a control program for controlling the quantum device 21. The control program is read from the storage device 14, and stored in the memory device 15 when starting the quantum computation system 1. Further, the arithmetic processing device 16 implements various kinds of processes as will be described later, according to the control program stored in the memory device 15.

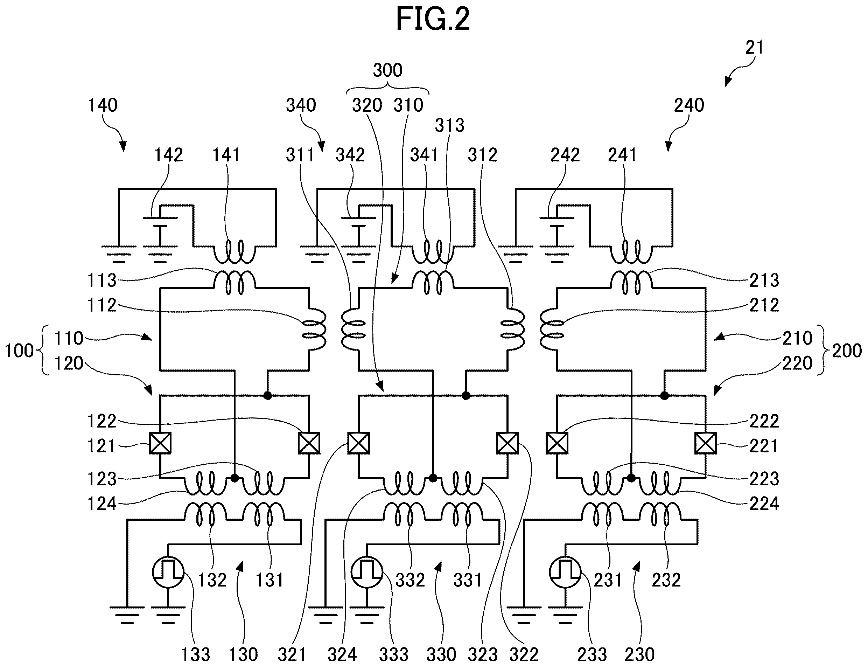

FIG. 2 is a circuit diagram illustrating the quantum device 21. The quantum device 21 includes a flux qubit 100, a flux qubit 200, and a coupling flux qubit 300. The coupling flux qubit 300 can inductively couple with the flux qubits 100 and 200. Although the flux qubit 100 and the flux qubit 200 are inductively coupled in this example, the form of coupling may be a capacitive coupling, or may include an inductive coupling and a capacitive coupling. The quantum device 21 further includes magnetic flux application units 130, 140, 230, 240, 330, and 340.

The flux qubit 100 includes a main loop 110, and a Superconducting Quantum Interference Device (SQUID) 120. The SQUID 120 includes a Josephson junction element 121, a Josephson junction element 122, an inductor 123, and an inductor 124, which are connected in series in this order in a ring shape. The main loop 110 includes inductors 112 and 113 connected in series to each other. An end of the inductor 112 opposite to the inductor 113 is connected between the Josephson junction element 121 and the Josephson junction element 122. An end of the inductor 113 opposite to the inductor 112 is connected between the inductor 123 and the inductor 124. For example, the flux qubit 100 includes niobium as a superconducting material. The flux qubit 100 is an example of a first qubit and a first flux qubit.

The flux qubit 200 has a main loop 210, and a SQUID 220. The SQUID 220 includes a Josephson junction element 221, a Josephson junction element 222, an inductor 223, and an inductor 224, which are connected in series in this order in a ring shape. The main loop 210 includes inductors 212 and 213 connected in series to each other. An end of the inductor 213 opposite to the inductor 212 is connected between the Josephson junction element 221 and the Josephson junction element 222. An end of the inductor 212 opposite to the inductor 213 is connected between the inductor 223 and the inductor 224. For example, the flux qubit 200 includes niobium as the superconducting material. The flux qubit 200 is an example of a second qubit and a second flux qubit.

The coupling flux qubit 300 includes a main loop 310, and a SQUID 320. The SQUID 320 includes a Josephson junction element 321, a Josephson junction element 322, an inductor 323, and an inductor 324, which are connected in series in this order in a ring shape. The main loop 310 includes inductors 311, 313, and 312 connected in series in this order. An end of the inductor 312 opposite to the inductor 313 is connected between the Josephson junction element 321 and the Josephson junction element 322. An end of the inductor 311 opposite to the inductor 313 is connected between the inductor 323 and the inductor 324. The inductor 311 and the inductor 112 are inductively coupled to each other, and the inductor 312 and the inductor 212 are inductively coupled to each other.

The magnetic flux application unit 130 includes inductors 131 and 132, and a pulse signal generator 133. The inductors 131 and 132 are connected in series to each other. An end of the inductor 132 opposite to the inductor 131 is grounded. The pulse signal generator 133 is connected between an end of the inductor 131 opposite to the inductor 132, and the ground. The inductor 131 and the inductor 123 are inductively coupled to each other. The inductor 132 and the inductor 124 are inductively coupled to each other. The magnetic flux application unit 130 is an example of a second magnetic flux application unit.

The magnetic flux application unit 230 includes inductors 231 and 232, and a pulse signal generator 233. The inductors 231 and 232 are connected in series to each other. An end of the inductor 231 opposite to the inductor 232 is grounded. The pulse signal generator 233 is connected between an end of the inductor 232 opposite to the inductor 231, and the ground. The inductor 231 and the inductor 223 are inductively coupled to each other. The inductor 232 and the inductor 224 are inductively coupled to each other. The magnetic flux application unit 230 is an example of a third magnetic flux application unit.

The magnetic flux application unit 330 includes inductors 331 and 332, and a pulse signal generator 333. The inductors 331 and 332 are connected in series to each other. An end of the inductor 332 opposite to the inductor 331 is grounded. The pulse signal generator 333 is connected between an end of the inductor 331 opposite to the inductor 332, and the ground. The inductor 331 and the inductor 323 are inductively coupled to each other. The inductor 332 and the inductor 324 are inductively coupled to each other. The magnetic flux application unit 330 is an example of a first magnetic flux application unit.

The magnetic flux application unit 140 includes an inductor 141, and a DC power supply 142. The inductor 141 and a positive electrode of the DC power supply 142 are connected to each other. An end of the inductor 141 opposite to the DC power supply 142 is grounded. A negative electrode of the DC power supply 142 is grounded. The inductor 141 and the inductor 113 are inductively coupled to each other. The main loop 310 is an example of a ring wiring.

The magnetic flux application unit 240 includes an inductor 241, and a DC power supply 242. The inductor 241 and a positive electrode of the DC power supply 242 are connected to each other. An end of the inductor 241 opposite to the DC power supply 242 is grounded. A negative electrode of the DC power supply 242 is grounded. The inductor 241 and the inductor 213 are inductively coupled to each other.

The magnetic flux application unit 340 includes an inductor 341, and a DC power supply 342. The inductor 341 and a positive electrode of the DC power supply 342 are connected to each other. An end of the inductor 341 opposite to the DC power supply 342 is grounded. A negative electrode of the DC power supply 342 is grounded. The inductor 341 and the inductor 313 are inductively coupled to each other.

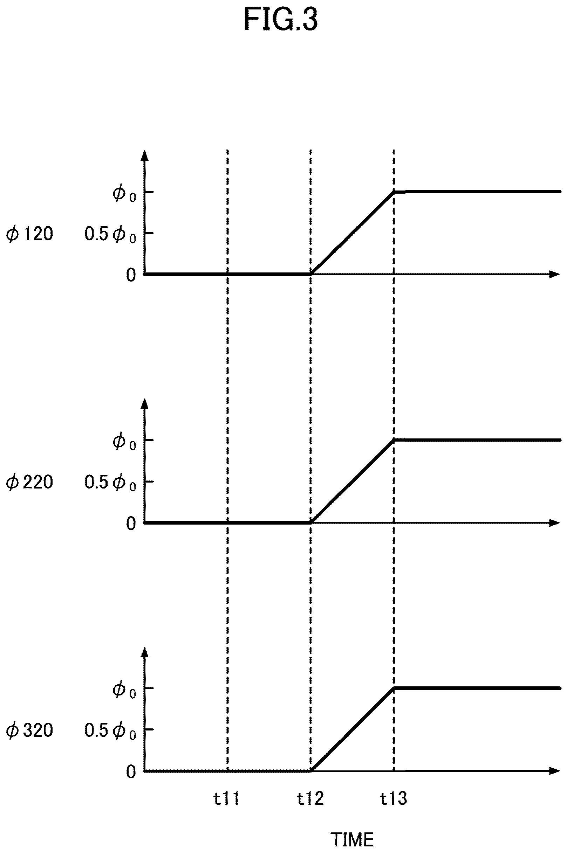

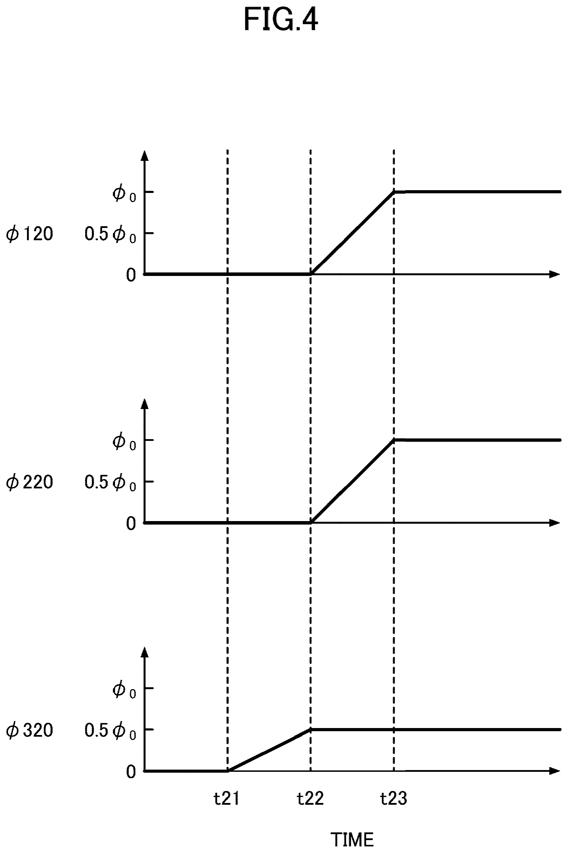

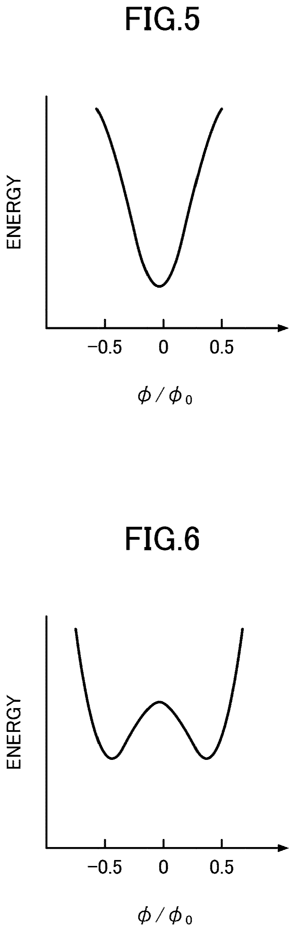

The control device 10 sets the coupling between the flux qubit 100 and the flux qubit 200 to an on state during a first time period, and sets the coupling between the flux qubit 100 and the flux qubit 200 to an off state during a second time period. FIG. 3 is a timing chart illustrating a temporal variation of a magnetic flux applied to the SQUIDs 120, 220, and 320 during the first time period. FIG. 4 is a timing chart illustrating a temporal variation of the magnetic flux applied to the SQUIDs 120, 220, and 320 during the second time period. FIG. 5 and FIG. 6 are diagrams illustrating an energy states of the flux qubit. In FIG. 3 and FIG. 4, Φ120 denotes a magnetic flux applied to the SQUID 120, Φ220 denotes a magnetic flux applied to the SQUID 220, and Φ320 denotes a magnetic flux applied to the SQUID 320. Φ₀ denotes a flux quantum. In FIG. 5 and FIG. 6, an abscissa indicates the magnetic flux applied to the main loop.

Although some of the inductors, such as the inductors 123 and 124, for example, are illustrated as separate inductors in FIG. 2, an inductor integrally including such inductors may be used. In addition, some of the DC power supplies, such as the DC power supply 142, for example, is an example of the power supply, and other forms of power supply, such as an arbitrary waveform source, may be used. The coupling between the flux qubit 200 and the coupling flux qubit 300 is an indirect coupling, and may be an inductive coupling, a capacitive coupling, or other forms of coupling.

As illustrated in FIG. 3, during the first time period, all of the magnetic fluxes Φ120, Φ220, and Φ320 are 0 (Wb) until a time t12, increase to Φ₀ from the time t12 to a time t13, and are Φ₀ from and after the time t13, by a control of the control device 10. The increase in the magnetic flux Φ320 may not be linear with respect to time. Energy potentials of the coupling flux qubit 300 in a case where Φ = 0 (Wb) and in a case where Φ = Φ₀ are equivalent to each other. For this reason, the magnetic flux Φ320 may be maintained at Φ₀ until the time t12, decreased to 0 (Wb) between the time t12 and the time t13, and controlled to 0 (Wb) from and after the time t13.

As illustrated in FIG. 4, during the second time period, both of the magnetic fluxes Φ120 and Φ220 are 0 (Wb) until a time t22, increase to Φ₀ from the time t22 to a time t23, and are Φ₀ from and after the time t23, by a control of the control device 10. On the other hand, the magnetic flux Φ320 is 0 (Wb) until a time t21 before the time t22, increases to 0.5Φ₀ from the time t21 to the time t22, and is 0.5Φ₀ from and after the time t22, by a control of the control device 10. The magnetic flux Φ320 may be controlled to 0.5Φ₀ before the time t22.

In each of the flux qubit 100, the flux qubit 200, and the coupling flux qubit 300, when the applied magnetic flux becomes Φ₀, two ground states are obtained as illustrated in FIG. 6. In addition, in each of the flux qubit 100, the flux qubit 200, and the coupling flux qubit 300, when the applied magnetic flux becomes 0.5Φ₀, the number of ground states becomes one as illustrated in FIG. 5. As illustrated in FIG. 5, an energy value of the ground state is low in the case where the number of energy ground states is one. On the other hand, as illustrated in FIG. 6, the energy value of the ground state in the case where the number of energy ground states is two is higher than that in the case illustrated in FIG. 5. During a time period between the time t22 and the time t23, in a case where the coupling flux qubit 300 assumes the state illustrated in FIG. 5, and there is a difference in the energy potentials between the flux qubit 100 and the flux qubit 200, a quantum tunneling phenomenon is less likely to occur between the flux qubit 100 and the flux qubit 200. For this reason, it is easy to control the coupling between the flux qubit 100 and the flux qubit 200 to an off state.

Accordingly, during the first time period, the magnetic fluxes Φ120, Φ220, and Φ320 simultaneously become 0.5Φ₀, and in the case where the magnetic fluxes Φ120, Φ220, and Φ320 are 0.5Φ₀, the flux qubit 100 and the flux qubit 200 assume a superposition state. Thereafter, in the case where the magnetic fluxes Φ120, Φ220, and Φ320 increase to Φ₀, the flux qubits 100 and 200 assume a classical state, and a solution converges. For this reason, during the first time period, the coupling between the flux qubit 100 and the flux qubit 200 is in the on state.

On the other hand, during the second time period, the magnetic flux Φ320 becomes 0.5Φ₀ before the magnetic fluxes Φ120 and Φ220 become 0.5Φ₀, and there is no time period in which and the flux qubit 100 and the flux qubit 200 assume the superposition state. For this reason, during the second time period, the coupling between the flux qubit 100 and the flux qubit 200 is in the off state.

### (First Simulation)

Next, a first simulation related to the first embodiment performed by the present inventor will be described. In the first simulation, the flux qubit 100 was set to a state capable of easily assuming a state "1" by controlling the magnetic flux application unit 140, and two kinds of biases were applied to the flux qubit 200 by controlling the magnetic flux application unit 240. One bias was set so that a probability of the state "1" of flux qubit 200 is 50%, and the other bias was set so that the flux qubit 200 is likely to assume a state "0". Further, the first time period and the second time period described above were controlled. In addition, as a reference, the magnetic fluxes Φ120 and Φ220 were varied in the same manner as in the first time period, on an assumption that the coupling flux qubit 300 is not provided.

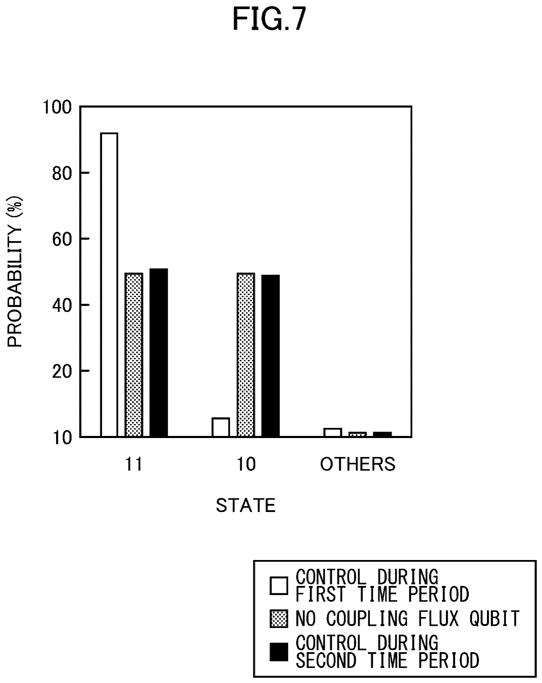

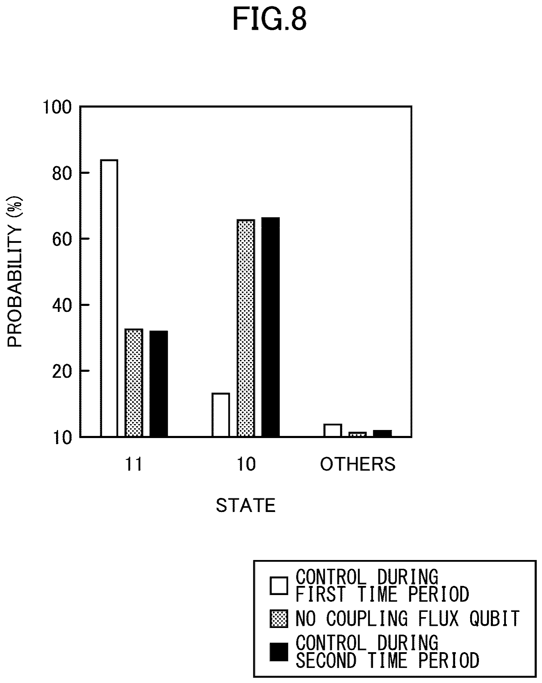

In the first simulation, the number of trials was set to 1000. Results of the first simulation are illustrated in FIG. 7 and FIG. 8. FIG. 7 illustrates the result for a case where the probability of the state "1" of the flux qubit 200 is 50%, and FIG. 8 illustrates the result for a case where the flux qubit 200 is likely to be in the state "0". In FIG. 7 and FIG. 8, "11" indicates that both flux qubit 100 and flux qubit 200 assume the state "1", and "10" indicates that flux qubit 100 assumes the state "1" and flux qubit 200 assumes the state "0".

As illustrated in FIG. 7, even in the case where the probability of the state "1" of the flux qubit 200 is set to 50%, the flux qubit 200 also assumed the state "1" with a high probability when the first time period is controlled. In addition, when the second time period is controlled, the same result as that obtained when the coupling flux qubit 300 is not operated was obtained.

As illustrated in FIG. 8, even in the case where the flux qubit 200 is made to easily assume the state "0", the flux qubit 200 also assumed the state "1" with a high probability when the first time period is controlled. Moreover, when the second time period is controlled, the same result as that obtained when the coupling flux qubit 300 is not operated was obtained.

It may be regarded from the above that the coupling between the flux qubit 100 and the flux qubit 200 is in the on state during the first time period, and the coupling between the flux qubit 100 and the flux qubit 200 is in the off state during the second time period.

### (Second Simulation)

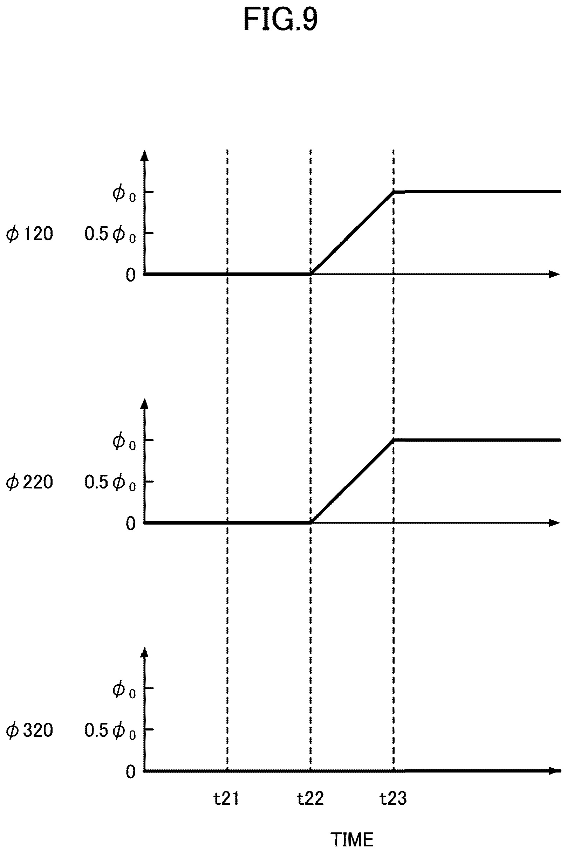

Next, a second simulation related to the first embodiment performed by the present inventor will be described. In the second simulation, various kinds of controls were performed as the control of the second time period. In the second simulation, similar to the first simulation, the flux qubit 100 was set to a state capable of easily assuming the state "1" by controlling the magnetic flux application unit 140, and two kinds of biases were applied to the flux qubit 200 by controlling the magnetic flux application unit 240. One bias was set so that a probability of the state "1" of flux qubit 200 is 50%, and the other bias was set so that a probability of the state "0" of flux qubit 200 is 70%. FIG. 9 through FIG. 12 are timing charts illustrating temporal variations of the magnetic fluxes applied to the SQUIDs 120, 220, and 320 during the second time period in the second simulation. In control patterns illustrated in FIG. 9 through FIG. 12, the temporal variations of the magnetic fluxes applied to the SQUIDs 120 and 220 are identical to that of a control pattern C illustrated in FIG. 4.

In a control pattern A illustrated in FIG. 9, the magnetic flux Φ320 is always set to 0 (Wb).

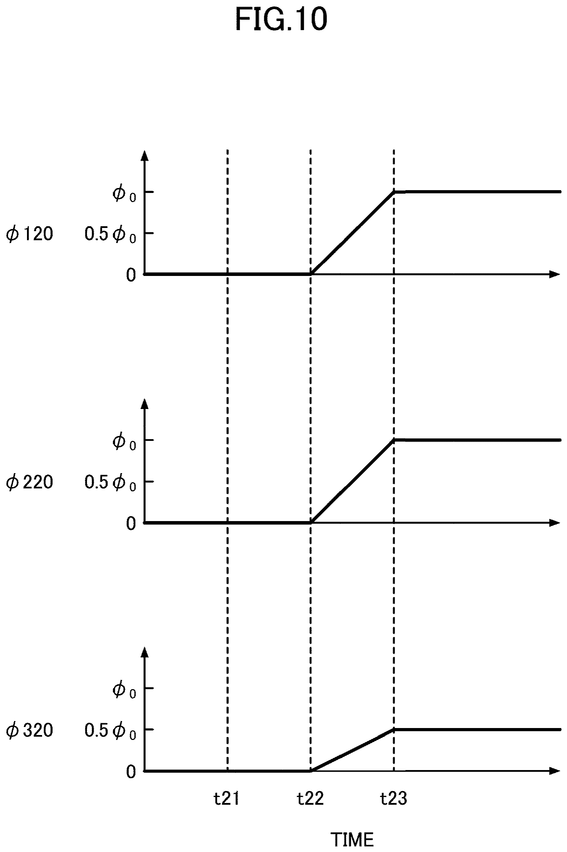

In a control pattern B illustrated in FIG. 10, the flux Φ320 is 0 (Wb) until the time t22, increased to 0.5Φ₀ from the time t22 to the time t23, and set to 0.5Φ₀ from and after the time t23.

In the control pattern C illustrated in FIG. 4, the flux Φ320 is 0 (Wb) until the time t21, increased to 0.5Φ₀ from the time t21 to the time t22, and set to 0.5Φ₀ from and after the time t22.

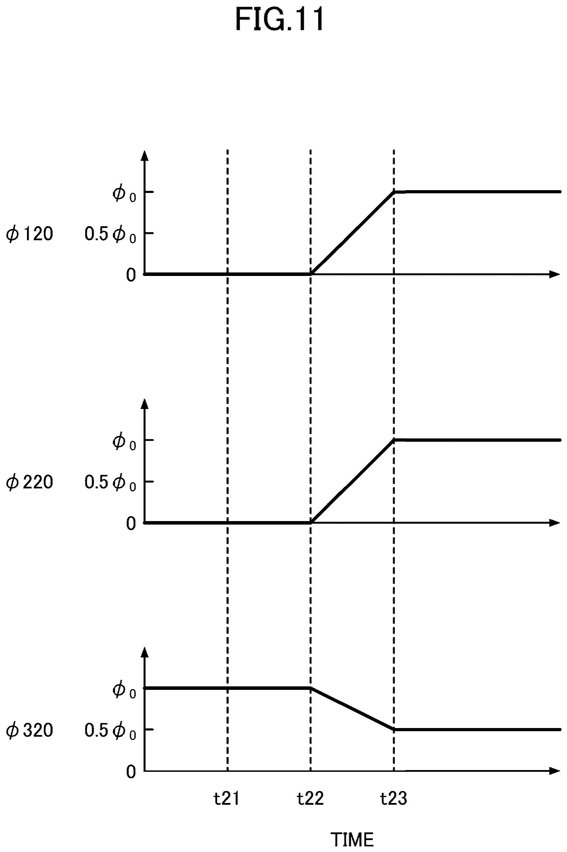

In a control pattern D illustrated in FIG. 11, the flux Φ320 is Φ₀ until the time t22, decreased to 0.5Φ₀ from the time t22 to the time t23, and set to 0.5Φ₀ from and after the time t23.

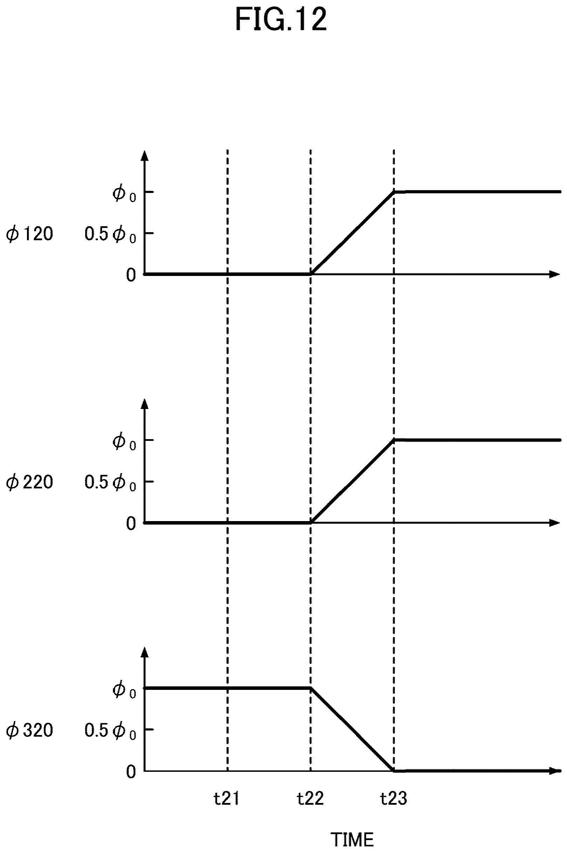

In a control pattern E illustrated in FIG. 12, the flux Φ320 is Φ₀ until the time t22, decreased to 0 (Wb) from the time t22 to the time t23, and set to 0 (Wb) from and after the time t23.

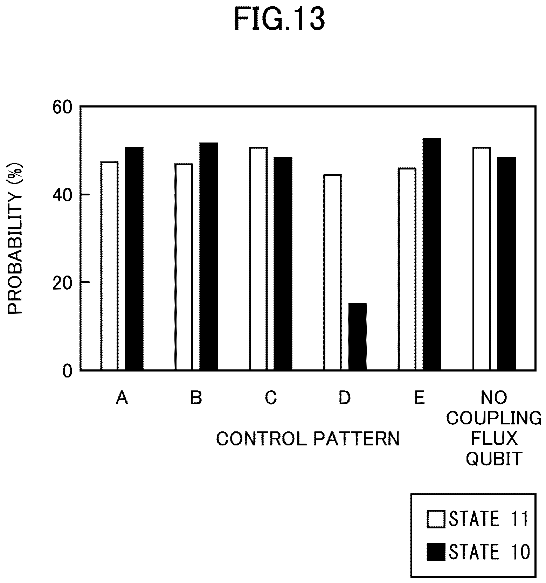

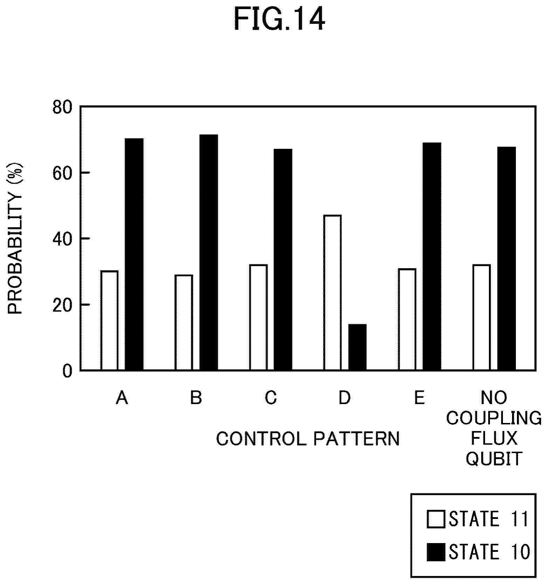

In the second simulation, the number of trials was set to 1000. Results of the second simulation are illustrated in FIG. 13 and FIG. 14. FIG. 13 illustrates the result for a case where the probability of the state "1" of the flux qubit 200 is 50%, and FIG. 14 illustrates the result for a case where the probability of the state "0" of flux qubit 200 is 70%. In FIG. 13 and FIG. 14, "11" indicates that both flux qubit 100 and flux qubit 200 assume the state "1", and "10" indicates that flux qubit 100 assumes the state "1" and flux qubit 200 assumes the state "0".

As illustrated in FIG. 13 and FIG. 14, in the control patterns B and C, results close to the case where the magnetic fluxes Φ120 and Φ220 were varied in the same manner as in the first time period, on the assumption that the coupling flux qubit 300 is not provided, were obtained. Particularly, in the control pattern C, the result was closest to the case where the coupling flux qubit 300 was not provided. In the control pattern B and the control pattern C in which the magnetic flux is biased so that the energy potential of the coupling flux qubit 300 has one ground state as illustrated in FIG. 5, a resistance to sudden changes in magnetic flux from external sources is higher and a stability thereof is higher when compared to the control pattern A in which the magnetic flux is not biased. In the control pattern B and the control pattern C, a quantum tunneling effect is reduced during a time period between the time t22 and the time t23, because there are differences in energy potentials between the flux qubit 100 and the coupling flux qubit 300 and between the flux qubit 200 and the coupling flux qubit 300. For this reason, in the control pattern B and the control pattern C, it is easier to control the coupling between the flux qubit 100 and the flux qubit 200 to the off state when compared to the control pattern A.

### (Third Simulation)

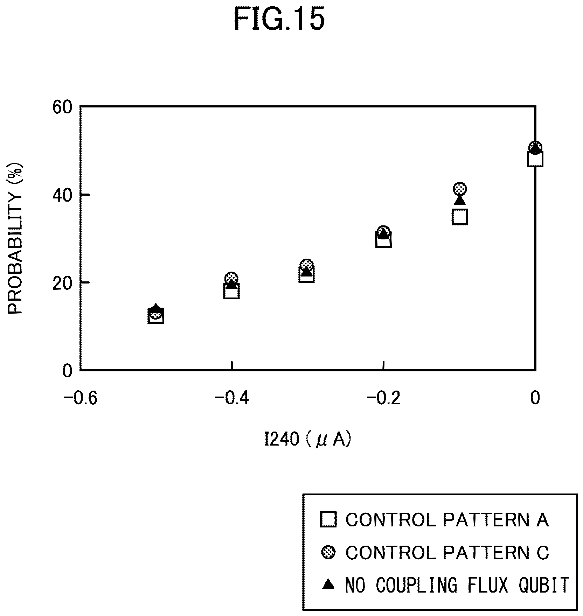

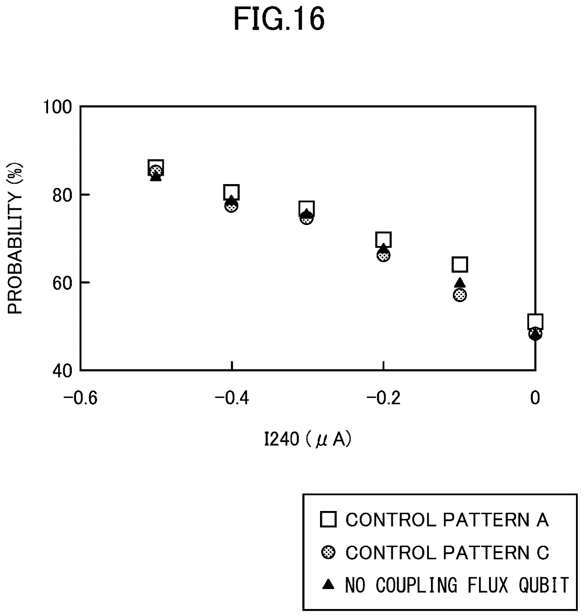

Next, a third simulation related to the first embodiment performed by the present inventor will be described. In the third simulation, results of the control patterns A and C and a case where the coupling flux qubit 300 is not provided were compared while a bias current I240 applied to the flux application unit 240 is varied. In the third simulation, the number of trials was set to 1000. Results of the third simulation are illustrated in FIG. 15 and FIG. 16. The ordinate in FIG. 15 indicates a probability of a state "11" where both the flux qubit 100 and the flux qubit 200 are in the state "1". The ordinate in FIG. 16 indicates a probability of a state "10" where the flux qubit 100 is in the state "1" and the flux qubit 200 is in the state "0".

As illustrated in FIG. 15 and FIG. 16, the control pattern C can obtain a result closer to the case where the coupling flux qubit 300 is not provided, when compared to the control pattern A.

From the results of the simulation described above, it was found that the control pattern C is particularly preferable. When taking into consideration variations in the energy potentials of the flux qubit 100 and the flux qubit 200, it is preferable that the magnetic flux Φ320 is in a range of 0.4Φ₀ to 0.6Φ₀ before the magnetic fluxes Φ120 and Φ220 becomes 0.3Φ₀.

The variations in the magnetic fluxes may occur in a time of 0.1 ns to 100 ms, or in a time of 1 µs to 1 ms, for example.

### (Second Embodiment)

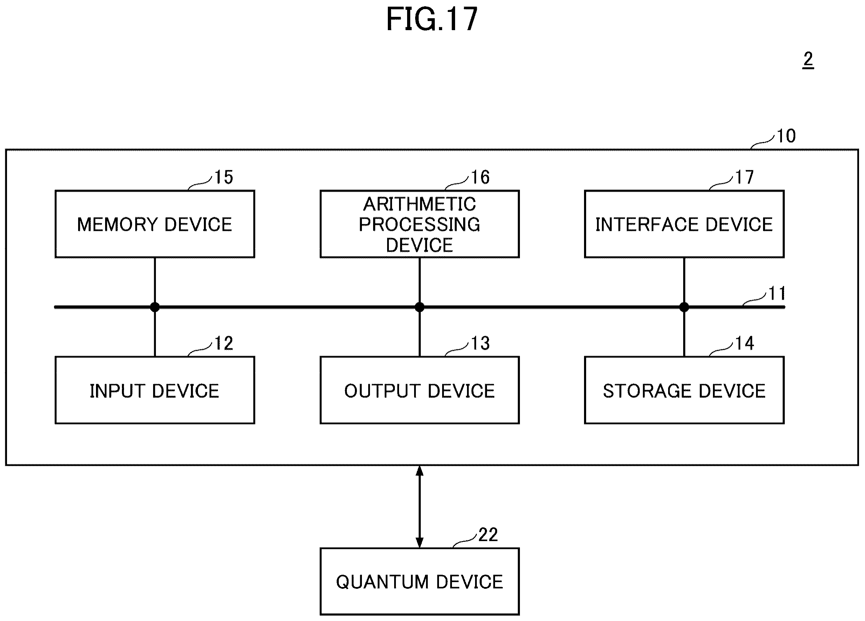

Next, a second embodiment will be described. The second embodiment relates to a quantum computation system. FIG. 17 is a block diagram illustrating the quantum computation system according to the second embodiment.

A quantum computation system 2 according to the second embodiment includes a control device 10, and a quantum device 21. The control device 10 controls the quantum device 21. A configuration of the control device 10 is the same as that of the first embodiment except for a content of the control program.

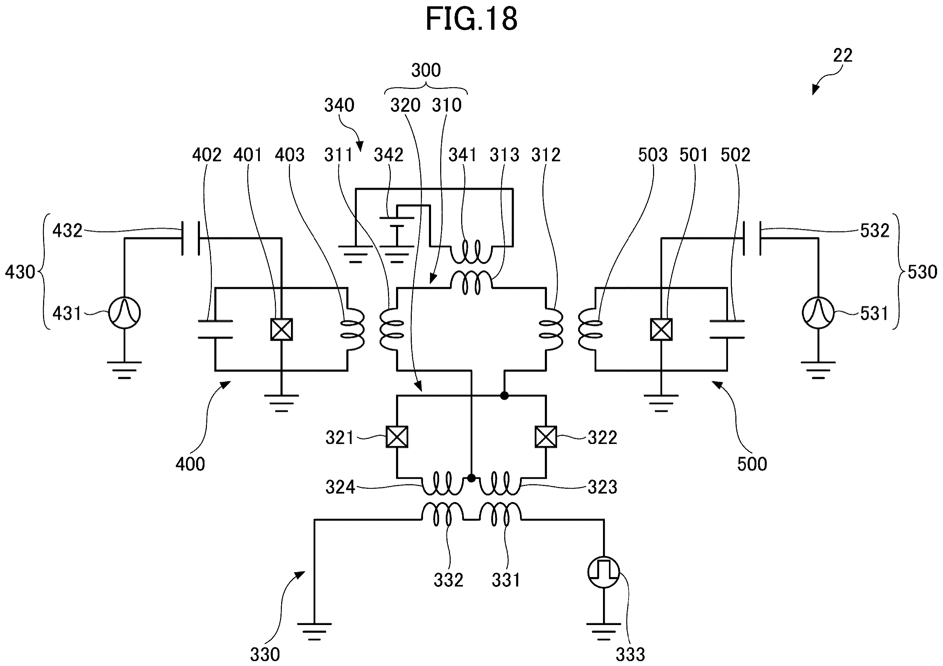

FIG. 18 is a circuit diagram illustrating the quantum device 22. The quantum device 22 includes charge qubit 400, a charge qubit 500, and coupling flux qubit 300. The coupling flux qubit 300 can be inductively coupled to charge qubits 400 and 500. The quantum device 22 further includes charge supply units 430 and 530. A configuration of the coupling flux qubit 300 is the same as that of the first embodiment.

The charge qubit 400 is a transmon qubit, for example, and includes a Josephson junction element 401 and a capacitor 402 that are connected to each other in a ring shape. The charge qubit 400 further includes an inductor 403 electrically connected in parallel to the Josephson junction element 401 and the capacitor 402. The inductor 403 and the inductor 311 are inductively coupled to each other. One end of each of the Josephson junction element 401, the capacitor 402, and the inductor 403 is grounded. For example, the charge qubit 400 includes titanium nitride as the superconducting material. The charge qubit 400 is an example of a first qubit and a first charge qubit. It is not essential to ground one end of each of the Josephson junction element 401, the capacitor 402, and the inductor 403, and even in the case where one end of each of the Josephson junction element 401, the capacitor 402, and the inductor 403 is grounded, the grounding end may be connected to a ground plane via a capacitor.

The charge supply unit 430 is connected to the other end of each of the Josephson junction element 401, the capacitor 402, and the inductor 403. The charge supply unit 430 includes a current source 431, and a capacitor 432. The capacitor 432 is connected between one end of the current source 431, and each of the current source 431 and the Josephson junction element 401, the capacitor 402, and the inductor 403. The other end of the current source 431 is grounded.

The charge qubit 500 is a transmon qubit, for example, and includes a Josephson junction element 501 and a capacitor 502 that are connected to each other in a ring shape. The charge qubit 500 further includes an inductor 503 electrically connected in parallel to the Josephson junction element 501 and the capacitor 502. The inductor 503 and the inductor 312 are inductively coupled to each other. One end of each of the Josephson junction element 501, the capacitor 502, and the inductor 503 is grounded. For example, charge qubit 500 includes titanium nitride as the superconducting material. The charge qubit 500 is an example of a second qubit and a second charge qubit.

The charge supply unit 530 is connected to the other end of each of the Josephson junction element 501, the capacitor 502, and the inductor 503. The charge supply unit 530 includes a current source 531, and a capacitor 532. The capacitor 532 is connected between one end of the current source 531, and each of the Josephson junction element 501, the capacitor 502, and the inductor 503. The other end of the current source 531 is grounded.

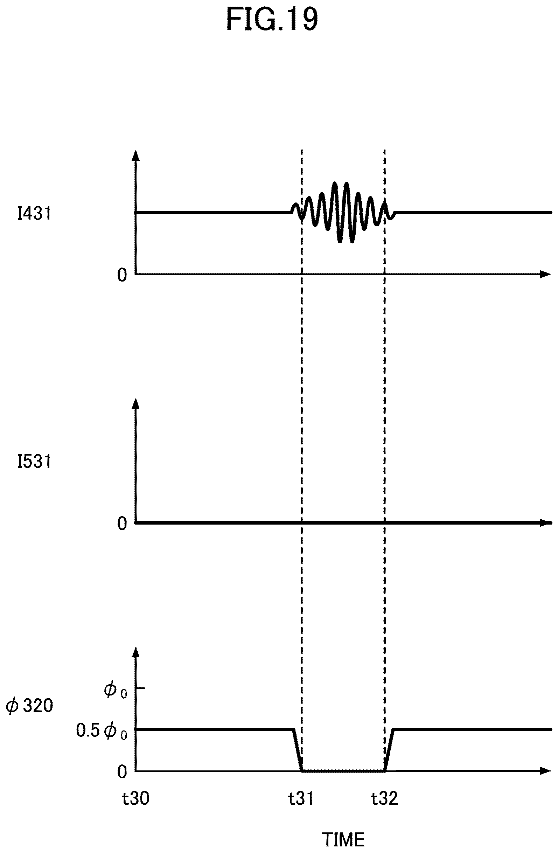

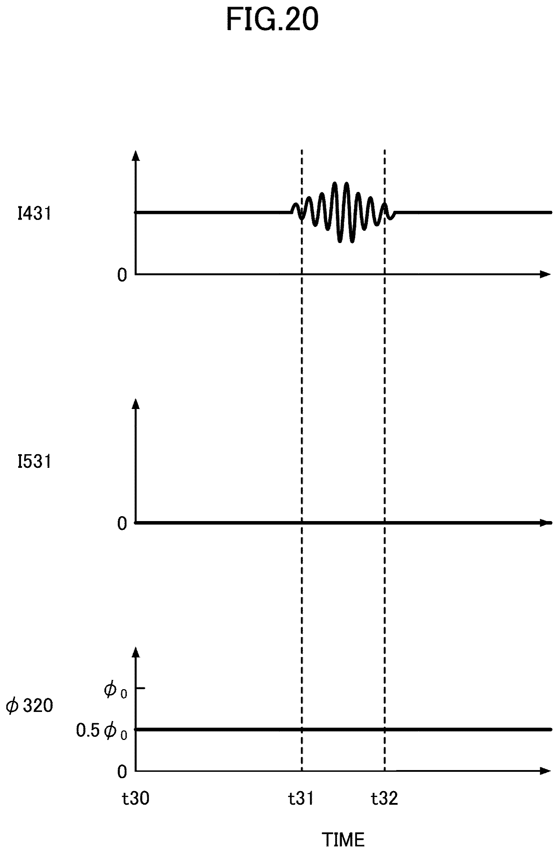

The control device 10 sets the coupling between the charge qubit 400 and the charge qubit 500 to the on state during the first time period, and sets the coupling between the charge qubit 400 and the charge qubit 500 to the off state during the second time period. FIG. 19 is a timing chart illustrating temporal variations of the current generated by the current source 431, the current generated by the current source 531, and the magnetic flux applied to the SQUID 320 during the first time period. FIG. 20 is a timing chart illustrating temporal variations of the current generated by the current source 431, the current generated by the current source 531, and the magnetic flux applied to the SQUID 320 during the second time period. In FIG. 19 and FIG. 20, I431 denotes a current generated by the current source 431, I531 denotes a current generated by the current source 531, and Φ320 denotes a magnetic flux applied to the SQUID 320.

A case where a gate operation is performed on the charge qubit 400 by setting the coupling between the charge qubit 400 and the charge qubit 500 to the on state will be described with reference to FIG. 19. In this example, a time period from a time t31 to the time t32 corresponds to the first time period. As illustrated in FIG. 19, during the first time period, the current source 431 generates a current for the gate operation so as to include times from the time t31 to the time t32 under the control of the control device 10. While the current source 431 is generating the current, the gate operation is performed on the charge qubit 400. The flux Φ320 becomes 0.5Φ₀ during a time period from a time t30 to the time t31 under the control of the control device 10. A current generated by the current source 531 is always 0 (A). Next, the flux Φ320 is set to 0 (Wb) during the time period between the time t31 and the time t32. During this time period, the coupling between charge qubit 400 and the charge qubit 500 is in the on state. Thereafter, at and after the time t32, the flux Φ320 is set to 0.5Φ₀ again. At and after the time t32, the flux Φ320 is preferably returned to 0.5Φ₀, but the flux Φ320 may be maintained at 0 (Wb) at and after the time t32. Because the energy potentials of the coupling flux qubit 300 in the case where Φ = 0 (Wb) and in the case where Φ = Φ₀ are equivalent to each other, the flux Φ320 may be set to Φ = Φ₀ during the time period between the time t31 and the time t32.

Next, a case where the gate operation is performed on the charge qubit 400 by setting the coupling between the charge qubit 400 and the charge qubit 500 to the off state will be described with reference to FIG. 20. In this example, a time period from the time t31 to the time t32 corresponds to the second time period. As illustrated in FIG. 20, the current source 431 generates a current for the gate operation so as to include times from time t31 to time t32 under the control of the control device 10. While the current source 431 is generating the current, the gate operation is performed on the charge qubit 400. The flux Φ320 becomes 0.5Φ₀ during a time period from the time t31 to the time t32 (the second time period) under the control of the control device 10. A current generated by the current source 531 is always 0 (A). FIG. 20 illustrates an example in which the magnetic flux Φ320 is controlled to 0.5Φ₀ during the time period from the time t30 to the time t31, and also during the time period at and after the time t32.

As described above, when the applied magnetic flux becomes 0 (Wb) or Φ₀ in the coupling flux qubit 300, there are two ground states as illustrated in FIG. 6, and when the applied magnetic flux becomes 0.5Φ₀ in the coupling flux qubit 300, there is one ground state as illustrated in FIG. 5. Next, a description will be given of the coupling that can be controlled to the on state when the magnetic flux applied to the coupling flux qubit 300 is set to 0 (Wb) or Φ₀, and the coupling that can be controlled to the off state when the magnetic flux applied to the coupling flux qubit 300 is set to 0.5Φ₀.

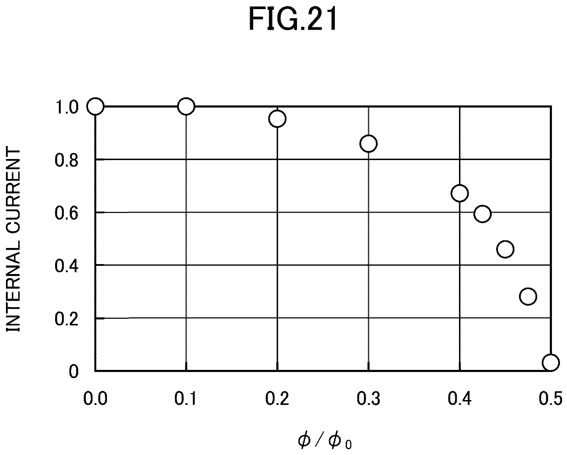

FIG. 21 is a diagram illustrating a relationship between the magnetic flux of the coupling flux qubit 300 and an internal current of the charge qubit 400 to be coupled to the coupling flux qubit 300. FIG. 21 illustrates a result of a simulation obtained by setting a resonance frequency of the charge qubit 400 and the charge qubit 500 to 8.1 GHz. An internal state of the charge qubit 400 was calculated, and an internal current Iₚ was observed, when excitation signal of 8.1 GHz is applied to the charge qubit 500 from the current source 531 as a signal generator. In this example, an intensity of a signal (an output signal of the pulse signal generator 333) applied to the coupling flux qubit 300 was modulated.

The ordinate in FIG. 21 indicates a value obtained by normalizing the internal current Iₚ according to the signal intensity (a magnetic flux applied by the pulse signal generator 333), using the internal current Iₚ when the signal intensity is 0 as a reference. It can be seen that the coupling between charge qubit 400 and charge qubit 500 is in the on state when the magnetic flux is 0 (Wb), while the coupling is in the off state when the magnetic flux is 0.5Φ₀.

It was confirmed by simulation that the same tendency as in FIG. 21 can be obtained even in a case where Xmon is used in place of the charge qubit 400 and the charge qubit 500, although the resonance frequency differs.

Xmon is a flux qubit composed of a single-layer wiring, and includes niobium, titanium nitride, or niobium nitride as the superconducting material, for example. The coupling between the coupling flux qubit 300 and the charge qubits 400 and 500 may be capacitive coupling.

### (First Example of Configuration of Quantum Device 22)

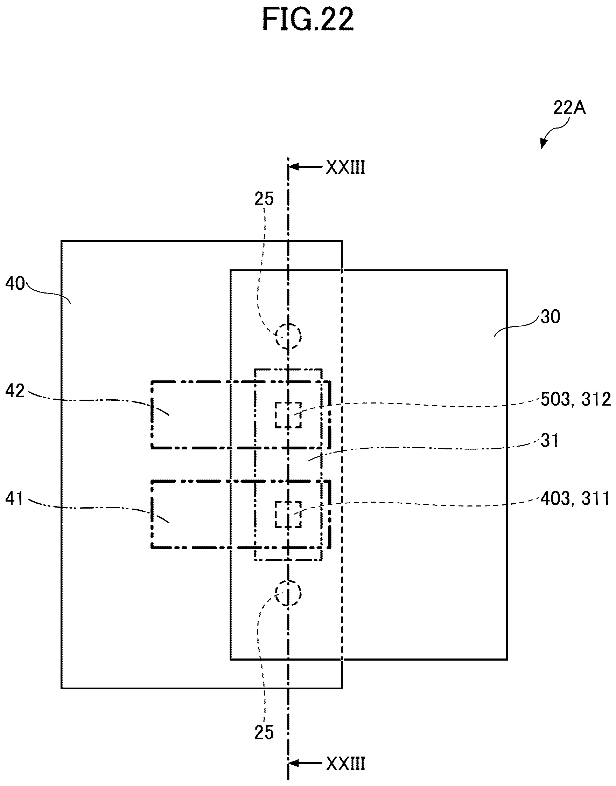

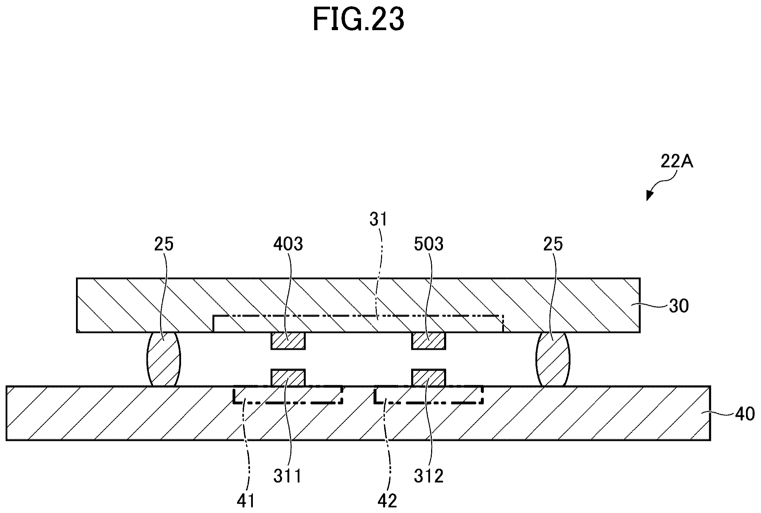

Next, a first example of a configuration of the quantum device 22 will be described. FIG. 22 is a plan view illustrating the first example of the configuration of the quantum device 22. FIG. 23 is a cross sectional view illustrating the first example of the configuration of the quantum device 22. FIG. 23 corresponds to a cross sectional view taken along a line XXIII-XXIII in FIG. 22.

As illustrated in FIG. 22 and FIG. 23, a quantum device 22A according to the first example includes a qubit substrate 30, and a qubit substrate 40. The qubit substrate 30 and the qubit substrate 40 are bonded to each other via bumps 25. For example, the qubit substrate 30 is flip-chip bonded to the qubit substrate 40. For example, the bumps 25 are connected to a ground layer provided on the qubit substrate 30 and a ground layer provided on the qubit substrate 40.

The qubit substrate 30 includes a coupling flux qubit 300, a magnetic flux application unit 330, and a magnetic flux application unit 340. The qubit substrate 30 includes a qubit area 31 in which the coupling flux qubit 300 is arranged.

Although not illustrated in FIG. 23, the qubit substrate 40 may include wirings and electrodes connected to the flux qubits 100 and 200. The qubit is not limited to the flux qubit, and may be other qubits. In addition, the qubit substrate 40 may include a resonator for observing a state of the qubit, and an electrode for manipulating the state of the qubit. Moreover, a path for introducing a signal for manipulating the state of the qubit may be formed by a wire-bonding from an end portion of the qubit substrate 40, or the signal may be supplied from a back surface of the qubit substrate 40 by providing a through hole in the qubit substrate 40. The qubit substrate 30 may have a path for supplying a signal at an end portion or a back surface of the qubit substrate 30. Further, the signal may be supplied to the qubit substrate 30 from the back surface thereof via the end portion or via the through hole of the qubit substrate 40, by connecting to a pattern provided on the qubit substrate 40 via a bump.

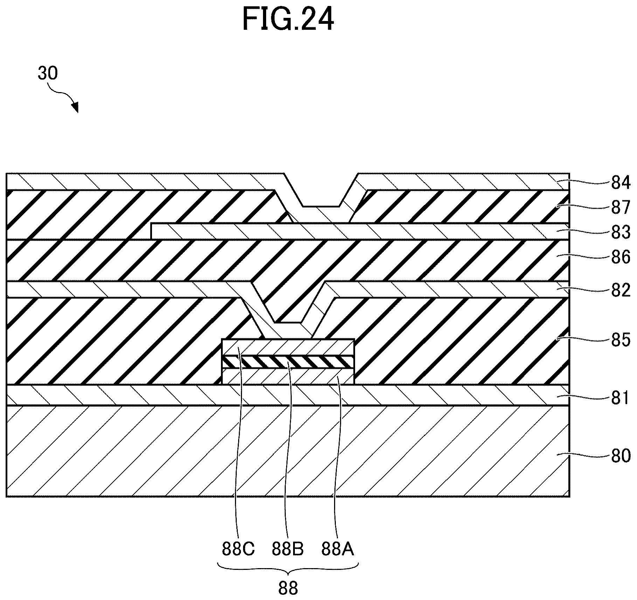

FIG. 24 is a cross sectional view illustrating a portion of the qubit substrate 30. The qubit substrate 30 includes a substrate 80, interconnect layers 81, 82, 83, and 84, insulating layers 85, 86, and 87, and a Josephson junction element 88, for example. The interconnect layer 81 is provided on the substrate 80, and the Josephson junction element 88 is provided on the interconnect layer 81. The insulating layer 85 is provided on the substrate 80 so as to cover the Josephson junction element 88 and the interconnect layer 81. The interconnect layer 82 is provided on the insulating layer 85 so as to make contact with the Josephson junction element 88 through an opening formed in the insulating layer 85. The insulating layer 86 is provided on the insulating layer 85 so as to cover the interconnect layer 82. The interconnect layer 83 is provided on the insulating layer 86. The insulating layer 87 is provided on the insulating layer 86 so as to cover the interconnect layer 83. The interconnect layer 84 is provided on the insulating layer 87 so as to make contact with the interconnect layer 83 through an opening formed in the insulating layer 87. A material used for the interconnect layers 81, 82, 83, and 84 is a material that can be a superconductor, such as niobium, niobium nitride, or the like, for example. A material used for the insulating layers 85, 86, and 87 is silicon oxide, for example.

The Josephson junction element 88 includes an aluminum film 88A, an aluminum oxide film 88B, and an aluminum film 88C, for example. The aluminum film 88A is connected to the interconnect layer 81. The aluminum oxide film 88B is provided on the aluminum film 88A. The aluminum film 88C is provided on the aluminum oxide film 88B, and the interconnect layer 82 makes contact with the aluminum film 88C. The Josephson junction element 88 corresponds to the Josephson junction elements 321 and 322.

The qubit substrate 40 includes a charge qubit 400, a charge supply unit 430, a charge qubit 500, and a charge supply unit 530. The qubit substrate 40 includes a qubit area 41 in which the charge qubit 400 is arranged, and a qubit area 42 in which the charge qubit 500 is arranged.

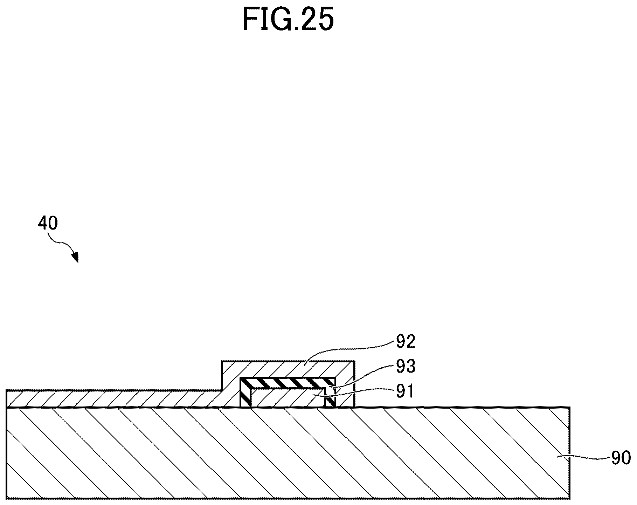

FIG. 25 is a cross sectional view illustrating a portion of the qubit substrate 40. The qubit substrate 40 includes a substrate 90, interconnect layers 91 and 92, and an insulating layer 93, for example. The interconnect layer 91 is provided on the substrate 90, and the insulating layer 93 covers the surface of the interconnect layer 91. The interconnect layer 92 is provided on the insulating layer 93. The interconnect layers 91 and 92 and the insulating layer 93 constitute a Josephson junction element corresponding to the Josephson junction elements 401 and 501.

The inductor 311 of the coupling flux qubit 300 and the inductor 403 of the charge qubit 400 oppose each other and are inductively coupled to each other. The inductor 312 of the coupling flux qubit 300 and the inductor 503 of the charge qubit 500 oppose each other and are inductively coupled to each other.

For example, the inductors 311 and 312 of the coupling flux qubit 300 are connected to the interconnect layer 84, a portion of the interconnect layer 84 and the inductor 403 are inductively coupled to each other, and another portion of the interconnect layer 84 and the inductor 503 are inductively coupled to each other.

### (Second Example of Configuration of Quantum Device 22)

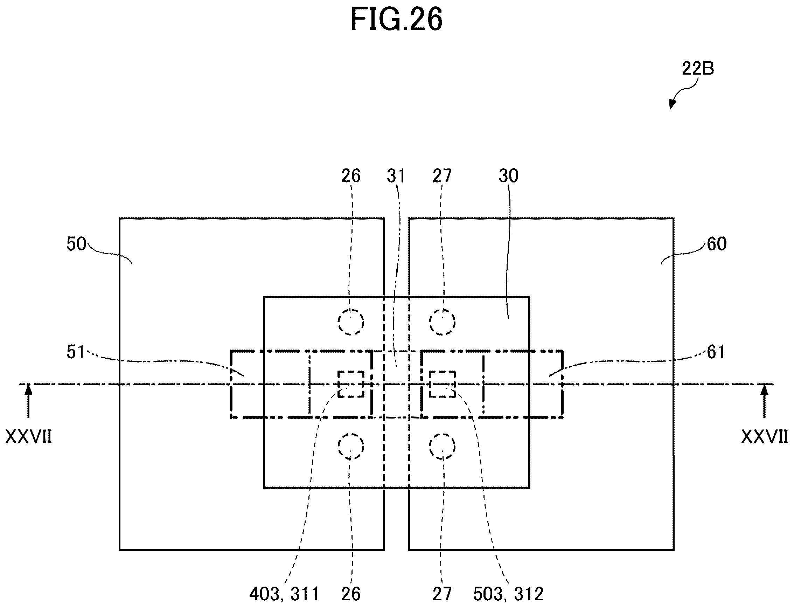

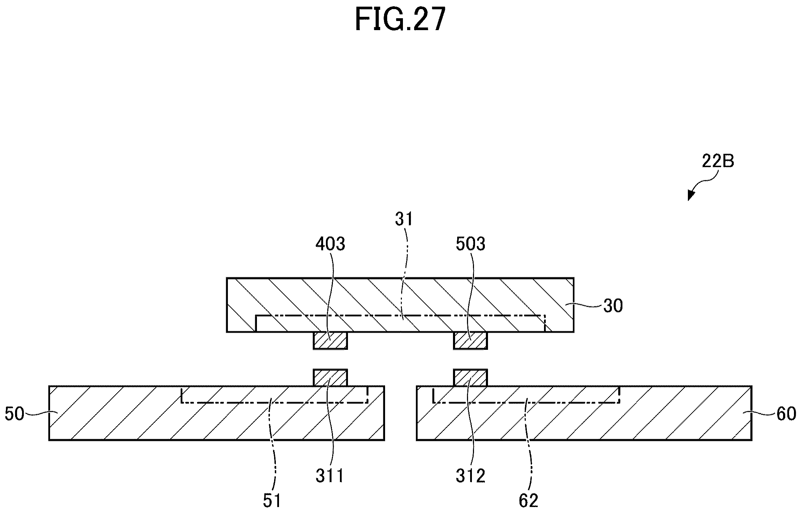

Next, a second example of the configuration of the quantum device 22 will be described. FIG. 26 is a plan view illustrating the second example of the configuration of the quantum device 22. FIG. 27 is a cross sectional view illustrating the second example of the configuration of the quantum device 22. FIG. 27 corresponds to a cross sectional view taken along a line XXVII-XXVII in FIG. 26.

As illustrated in FIG. 26 and FIG. 27, a quantum device 22B according to the second example includes a qubit substrate 30, a qubit substrate 50, and a qubit substrate 60. The qubit substrate 30 and the qubit substrate 50 are bonded to each other via bumps 26, and the qubit substrate 30 and the qubit substrate 60 are bonded to each other via bumps 27. For example, the qubit substrate 30 is flip-chip bonded to the qubit substrates 50 and 60. For example, the bumps 26 are connected to a ground layer provided on the qubit substrate 30 and a ground layer provided on the qubit substrate 50, and the bumps 27 are connected to the ground layer provided on the qubit substrate 30 and a ground layer provided on the qubit substrate 60.

The qubit substrate 50 includes a charge qubit 400, and a charge supply unit 430. The qubit substrate 50 includes a qubit area 51 in which the charge qubit 400 is arranged. The qubit substrate 60 includes a charge qubit 500, and a charge supply unit 530. The qubit substrate 60 includes a qubit area 61 in which the charge qubit 500 is arranged.

The inductor 311 of the coupling flux qubit 300 and the inductor 403 of the charge qubit 400 oppose each other and are inductively coupled to each other. The inductor 312 of the coupling flux qubit 300 and the inductor 503 of the charge qubit 500 oppose each other and are inductively coupled to each other.

For example, the inductors 311 and 312 of the coupling flux qubit 300 are connected to the interconnect layer 84, a portion of the interconnect layer 83 or 84 and the inductor 403 are inductively coupled to each other, and another portion of the interconnect layer 83 or 84 and the inductor 503 are inductively coupled to each other.

Although not illustrated in FIG. 27, the qubit substrate 50 and the qubit substrate 60 may include a qubit, and a wiring or an electrode directly or indirectly connected to the qubit. In addition, the qubit substrate 50 and the qubit substrate 60 may include a resonator for observing a state of the qubit, and an electrode for manipulating the state of the qubit. Moreover, a path for introducing a signal for manipulating the state of the qubit may be formed by a wire-bonding from end portions of the qubit substrate 50 and the qubit substrate 60, or the signal may be supplied from back surfaces of the qubit substrate 50 and the qubit substrate 60 by providing through holes in the qubit substrate 40 and the qubit substrate 60. The qubit substrate 30 may have a path for supplying a signal at the end portion or the back surface of the qubit substrate 30. Further, the signal may be supplied to the qubit substrate 50 and the qubit substrate 60 from the back surfaces via the end portions or via the through holes of the qubit substrate 50 and the qubit substrate 60, by connecting to patterns provided on the qubit substrate 50 and the qubit substrate 60 via bumps.

Otherwise, the configuration is the same as that of the first example.

### (Third Example of Configuration of Quantum Device 22)

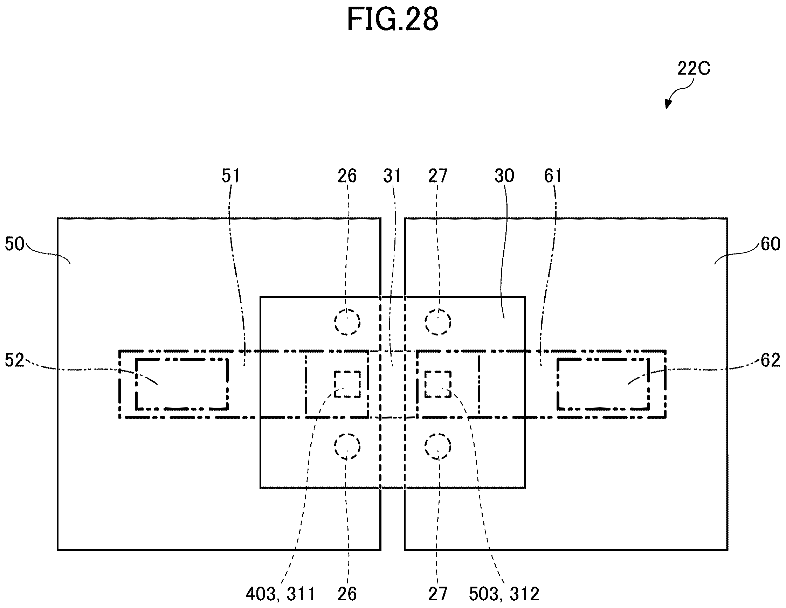

Next, a third example of the configuration of the quantum device 22 will be described. FIG. 28 is a plan view illustrating the third example of the configuration of the quantum device 22.

As illustrated in FIG. 28, in a quantum device 22C according to the third example, an area 52 of the qubit area 51, provided with the Josephson junction element 401 and the capacitor 402, is separated from the qubit substrate 30 in the plan view. In addition, an area 62 of the qubit area 61, provided with the Josephson junction element 501 and the capacitor 502, is separated from the qubit substrate 30 in the plan view.

Otherwise, the configuration is the same as that of the second example.

In the second example, the insulating layers 85, 86, and 87 included in the qubit substrate 30 can be dielectric loss sources with respect to the Josephson junction element 401 and the capacitor 402, and with respect to the Josephson junction element 501 and the capacitor 502. In the third example, however, such a dielectric loss can be reduced.

In the first example or the second example, in order to reduce the dielectric loss, a ground layer may be provided in a portion of the qubit substrate 30 corresponding to the Josephson junction element 401 and the capacitor 402, and a portion of the qubit substrate 30 corresponding to the Josephson junction element 501 and the capacitor 502.

A material used for the bumps 25, 26, and 27 is preferably a material capable of low-temperature bonding, such as indium, an indium alloy, or the like. The material used for the bumps 25, 26, and 27 is preferably a material that can be bonded at 200°C or lower, and more preferably a material that can be bonded at 180°C or lower. The material used for the bumps 25, 26, and 27 may be a material, such as gold or the like, that can improve adhesion. In addition, an alloy of indium and gold may be used as such a material. In this case, depending on the composition of the material, the bonding can be performed at a temperature of 180°C or lower, and the material becomes a superconducting material.

In the second example and the third example, the qubit substrate 30 and one of the qubit substrates 50 and 60 may be coupled to each other via a coaxial cable including a superconducting material (hereinafter, the coaxial cable including the superconducting material may be referred to as a superconducting cable). The superconducting material used for the superconductor cable is an alloy of niobium and titanium, for example.

For example, the qubit substrate 30 and the qubit substrate 50 are bonded to each other using the bumps 26 as in the second example, and the qubit substrate 30 and the qubit substrate 60 are coupled to each other via the superconducting cable. In this case, the inductor 312 of the coupling flux qubit 300 and the superconducting cable are inductively coupled to each other, and the superconducting cable and the inductor 503 of the charge qubit 500 are inductively coupled to each other, for example. For example, the qubit substrate 30 may be flip-chip bonded to the qubit substrate 50. A length of the superconducting cable may be several cm to several m, and is typically in a range of 1 m to 10 m. The coupling state between charge qubit 400 and charge qubit 500 can be adjusted by controlling the energy potential of coupling flux qubit 300.

The coupling between the superconducting cable and the charge qubit 400 or 500 may be a capacitive coupling, and the coupling between the superconducting cable and the coupling flux qubit 300 may be a capacitive coupling. In addition, a coupling portion may further include a superconducting circuit including a Josephson junction element, and the superconducting cable may be directly, inductively, or capacitively coupled to the charge qubit or the coupling flux qubit.

The qubit substrate 30 and the qubit substrate 60 may be bonded to each other using the bumps 27 as in the second example, and the qubit substrate 30 and the qubit substrate 50 may be coupled to each other via a superconducting cable. Further, the qubit substrate 30 and the qubit substrates 50 and 60 may be coupled via superconducting cables.

By coupling the qubit substrates using the superconducting cable, a degree of freedom of arrangement of the qubit substrates on a stage can be improved inside a single dilution refrigerator. For example, when arranging the qubit substrates on a lowest temperature stage of the dilution refrigerator, the qubit substrates may be arranged at positions distant from one another and protected by different magnetic shields. In addition, by using a long superconducting cable having a length of 5 m to 10 m, qubits of the qubit substrates provided in different dilution refrigerators can be coupled to each other.

In the first embodiment, it is preferable that an unstable state does not clearly appear in the shape of the energy potential of the coupling flux qubit 300 (refer to FIG. 6) when the magnetic flux application unit 330 applies the magnetic flux Φ₀ to the coupling flux qubit 300. For example, a value of a variable β_{L} represented by 2πLI_{C}/Φ₀ is preferably in a range of 1.2 to 8.0. In this case, L denotes a total inductance of the coupling flux qubit 300, and I_{C} denotes a sum of critical current values of the Josephson junction elements 321 and 322. The value of the variable β_{L} is more preferably in a range of 1.2 to 6.0, because an inflection point, which serves as a sign of an unstable state appearing in the energy potential, does not clearly appear.

For example, the critical current value I_{C} of the Josephson junction elements 321 and 322 may be in a range of 1.0 µA to 4.0 µA. The smaller the critical current value I_{C} becomes, the easier it becomes to widen a selection range of an overall inductance L of the coupling flux qubit 300. Further, the larger the critical current value I_{C} becomes, the narrower the selection range of the inductance L becomes, but the easier it becomes to stably form the Josephson junction elements 321 and 322.

In order for the number of ground states of the flux qubit to be one, the applied magnetic flux is set to 0.5Φ₀, but the magnetic flux does not necessary have to be set strictly to 0.5Φ₀, and may be set in a range of 0.4Φ₀ to 0.6Φ₀.

Moreover, the coupling flux qubit 300 may include a plurality of SQUIDs 320 connected in parallel to one another. In this case, variations in characteristics can be reduced.

The magnetic flux application unit 340 of the coupling flux qubit 300 may be omitted.

The quantum computation system and the quantum device according to the present disclosure can be used for quantum computing, for example.

Although the preferred embodiments or the like are described above in detail, the present disclosure is not limited to the embodiments or the like described above, and various modifications and substitutions can be made to the embodiments or the like described above without departing from the scope of the subject matter described in the claims.

### DESCRIPTION OF REFERENCE NUMERALS

1, 2: quantum computation system
10: control device
21, 22, 22A, 22B, 22C: quantum device
30, 40, 50, 60: qubit substrate
31, 41, 42, 51, 61: qubit area
100, 200: flux qubit
110, 210, 310: main loop
120, 220, 320: SQUID
130, 140, 230, 240, 330, 340: magnetic flux application unit
300: coupling flux qubit
400, 500: charge qubit
430, 530: charge supply unit

## Claims

1. A quantum computation system comprising:
a quantum device; and
a control device configured to control the quantum device,
wherein the quantum device includes:
a first qubit;
a second qubit;
a coupling flux qubit coupleable to the first qubit and the second qubit; and
a first magnetic flux application unit configured to apply a magnetic flux to the coupling flux qubit, and
wherein the control device causes the first magnetic flux application unit to:
apply a first magnetic flux having a first time modulation during a first time period; and
apply a second magnetic flux having a second time modulation different from the first time modulation during a second time period different from the first time period.

2. The quantum computation system as claimed in claim 1, wherein:
the first qubit includes a first flux qubit;
the second qubit includes a second flux qubit;
the quantum device includes:
a second magnetic flux application unit configured to apply a magnetic flux to the first flux qubit; and
a third magnetic flux application unit configured to apply a magnetic flux to the second flux qubit,
the control device causes the second magnetic flux application unit to:
apply a third magnetic flux having the first time modulation during the first time period; and
apply a fourth magnetic flux having a third time modulation different from the second time modulation during the second time period, and
the control device causes the third magnetic flux application unit to:
apply a fifth magnetic flux having the first time modulation during the first time period; and
apply a sixth magnetic flux having the third time modulation during the second time period.

3. The quantum computation system as claimed in claim 2, wherein:
the first flux qubit includes two ground states when applied with the fourth magnetic flux,
the second flux qubit includes two ground states when applied with the sixth magnetic flux, and
the coupling flux qubit includes one ground state when applied with the second magnetic flux.

4. The quantum computation system as claimed in claim 2 or 3, wherein:
in the third time modulation, the fourth magnetic flux and the sixth magnetic flux increase from 0 (Wb) to Φ₀, where Φ₀ denotes a flux quantum, and
in the second time modulation, the second magnetic flux is in a range of 0.4Φ₀ to 0.6Φ₀ during a time period in which the fourth magnetic flux and the sixth magnetic flux are Φ₀.

5. The quantum computation system as claimed in claim 4, wherein the second magnetic flux reaches the range of 0.4Φ₀ to 0.6Φ₀ before the fourth magnetic flux and the sixth magnetic flux reach Φ₀.

6. The quantum computation system as claimed in claim 4, wherein the second magnetic flux reaches the range of 0.4Φ₀ to 0.6Φ₀ simultaneously as when the fourth magnetic flux and the sixth magnetic flux reach Φ₀.

7. The quantum computation system as claimed in claim 1, wherein:
the first qubit includes Xmon;
the second qubit includes Xmon;
the coupling flux qubit includes two ground states when applied with the first magnetic flux; and
the coupling flux qubit includes one ground state when applied with the second magnetic flux.

8. The quantum computation system as claimed in claim 7, wherein:
the first magnetic flux is 0 (Wb) or Φ₀ during the first time period, where Φ₀ denotes a flux quantum, and
the second magnetic flux is in a range of 0.4Φ₀ to 0.6Φ₀ during the second time period.

9. The quantum computation system as claimed in any one of claims 1, 2, 3, 7, and 8, wherein a value of 2πLI_{C}/Φ₀ is in a range of 1.2 to 8.0, where L denotes an entire inductance of the coupling flux qubit, I_{C} denotes a critical current value of a Josephson junction element included in the coupling flux qubit, and Φ₀ denotes a flux quantum.

10. A quantum device control method for controlling a quantum device including:
a first qubit;
a second qubit; and
a coupling flux qubit coupleable to the first qubit and the second qubit,
wherein the quantum device control method comprises the steps of:
applying a first magnetic flux with a first time modulation to the coupling flux qubit during a first time period; and
applying a second magnetic flux having a second time modulation different from the first time modulation to the coupling flux qubit during a second time period different from the first time period.

11. The quantum device control method as claimed in claim 10, wherein:
the first qubit includes a first flux qubit; and
the second qubit includes a second flux qubit,
wherein the quantum device control method further comprises the steps of:
applying a third magnetic flux with the first time modulation to the first flux qubit, and applying a fifth magnetic flux with the first time modulation to the second flux qubit, during the first time period; and
applying a fourth magnetic flux with a third time modulation different from the second time modulation to the first flux qubit, and applying a sixth magnetic flux with the third time modulation to the second flux qubit, during the second time period.

12. The quantum device control method as claimed in claim 11, wherein:
the first flux qubit includes two ground states when applied with the fourth magnetic flux,
the second flux qubit includes two ground states when applied with the sixth magnetic flux, and
the coupling flux qubit includes one ground state when applied with the second magnetic flux.

13. The quantum device control method as claimed in claim 10, wherein:
the first qubit includes a first charge qubit, the second qubit includes a second charge qubit,
the coupling flux qubit includes two ground states when applied with the first magnetic flux, and
the coupling flux qubit includes one ground state when applied with the second magnetic flux.

14. The quantum device control method as claimed in claim 10, wherein:
the first qubit includes Xmon,
the second qubit includes Xmon,
the coupling flux qubit includes two ground states when applied with the first magnetic flux, and
the coupling flux qubit includes one ground state when applied with the second magnetic flux.

15. A quantum computation system comprising:
a quantum device; and
a control device configured to control the quantum device,
wherein the quantum device includes:
a first charge qubit;
a second charge qubit;
a coupling flux qubit coupleable to the first charge qubit and the second charge qubit; and
a first magnetic flux application unit configured to apply a magnetic flux to the coupling flux qubit, and
wherein the control device causes the first magnetic flux application unit to:
apply a magnetic flux that causes the coupling flux qubit to have one ground state of energy potential during a first time period, and causes the coupling flux qubit to have two ground states of energy potential during a second time period different from the first time period.

16. A quantum device control method for controlling a quantum device including:
a first charge qubit;
a second charge qubit;
a coupling flux qubit coupleable to the first charge qubit and the second charge qubit; and
a first magnetic flux application unit configured to apply a magnetic flux to the coupling flux qubit,
wherein the quantum device control method comprises the steps of:
applying a magnetic flux from the first magnetic flux application unit to the coupling flux qubit to have one ground state of energy potential during a first time period; and
applying a magnetic flux from the first magnetic flux application unit to the coupling flux qubit to have two ground states of energy potential during a second time period different from the first time period.
